Europäisches Patentamt

European Patent Office

Office européen des brevets

(11) Numéro de publication: **0 345 119**
**A1**

## DEMANDE DE BREVET EUROPEEN

(21) Numéro de dépôt: **89401402.6**

(22) Date de dépôt: **23.05.89**

(51) Int. Cl.⁴: **H 01 L 27/14**
**H 04 N 3/15**

(30) Priorité: **31.05.88 FR 8807215**

(43) Date de publication de la demande:
**06.12.89 Bulletin 89/49**

(84) Etats contractants désignés: **DE FR GB NL**

(71) Demandeur: **THOMSON-CSF**
**51, Esplanade du Général de Gaulle**
**F-92800 Puteaux (FR)**

(72) Inventeur: **Berger, Jean-Luc**
**THOMSON-CSF SCPI Cédex 67**
**F-92045 Paris la Défense (FR)**

**Apard, Paul**
**THOMSON-CSF SCPI Cédex 67**
**F-92045 Paris la Défense (FR)**

(74) Mandataire: **Guérin, Michel et al**
**THOMSON-CSF SCPI**
**F-92045 PARIS LA DEFENSE CEDEX 67 (FR)**

Le titre de l'invention a été modifié (Directives relatives à l'examen pratiqué à l'OEB, A-III, 7.3)

(54) **Dispositif photosensible à transfert de ligne.**

(57) Dispositif photosensible à transfert de ligne, du genre comportant entre chaque colonne conductrice d'une matrice photosensible et une entrée correspondante d'une mémoire de ligne, un injecteur constitué par une diode d'entrée reliée à la colonne et une grille dite de contrôle couplée à la colonne par un amplificateur de contre réaction, caractérisé par l'interposition entre ladite grille de contrôle (Gp1) et l'entrée (G1) de la mémoire de ligne, d'au moins une grille intermédiaire (Gp2) maintenue à une tension fixe.

Une telle grille intermédiaire permet de maîtriser le régime d'écoulement des charges en réduisant le niveau de bruit attribuable à l'action de l'amplificateur.

FIG.3

EP 0 345 119 A1

**Description**

## Perfectionnements aux dispositifs photosensibles à transfert de ligne

La présente invention concerne un dispositif photosensible à transfert de ligne muni d'amplificateurs de contre-réaction.

Les dispositifs photosensibles état solide analysés par la méthode du transfert de ligne doivent assurer le transfert des photocharges d'une même ligne à partir de colonnes conductrices d'une matrice photosensible vers un organe de lecture série du type à transfert de charge. Il s'agit d'un transfert depuis une capacité élevée vers une capacité plus faible qui doit être, pour un dispositif performant, à la fois rapide et peu bruyant. On a proposé pour atteindre cet objectif l'introduction d'un amplificateur de contre-réaction entre la colonne et la première grille d'écrémage de la mémoire de ligne: on se réfère notamment aux brevets français 83 05252 (HITACHI) et 84 15493 (THOMSON-CSF).

L'expérience confirme en effet qu'un tel amplificateur de contre-réaction permet une amélioration très sensible du temps de transfert. Il pose cependant un problème en ce qui concerne le bruit excédentaire qu'il ajoute à celui du transfert, ce qui limite l'intérêt de son utilisation.

La présente invention a pour objet un circuit de lecture amélioré permettant l'utilisation d'un tel amplificateur avec une réduction notable du bruit introduit.

L'invention propose à cet effet, dans un injecteur constitué par une diode d'entrée reliée à la colonne et une grille dite de contrôle couplée à la colonne par un amplificateur de contre-réaction, l'interposition, entre la grille de contrôle et l'entrée d'une mémoire de ligne desservie par l'injecteur, d'au moins une grille intermédiaire maintenue à une tension fixe.

De préférence, ladite tension fixe telle que la tension sous la grille intermédiaire soit intermédiaire entre la tension d'équilibre atteinte sous la grille de contrôle à la fin d'un transfert de charge et la tension sous la grille de contrôle au début du transfert.

Il s'est avéré en effet que la mise en oeuvre d'une telle grille intermédiaire permet de maîtriser le régime du transfert de charges de la colonne vers la mémoire de ligne et réduire ainsi avec une efficacité surprenante le bruit introduit dans le processus.

La tension fixe appliquée à la grille intermédiaire selon l'invention permet d'agir en particulier sur la vitesse d'écoulement des charges dans une période initiale du transfert, tandis que dans une seconde période le transfert demeure sous le contrôle de la grille de contrôle.

Selon un autre aspect de l'invention la grille intermédiaire est elle-même suivie d'une seconde grille intermédiaire formant barrière devant l'entrée de la mémoire de ligne, sous la commande d'une impulsion à deux niveaux de tension, à savoir un niveau bas d'isolement de la dite entrée et un niveau haut autorisant le transfert de charge vers celle-ci.

Une telle grille barrière constitue également un moyen de protection de la barrière de potentiel formée sous la grille intermédiaire contre des effets indésirables de modulation susceptibles de résulter de l'arrivée des charges sous la grille d'entrée de la mémoire.

Les caractéristiques et avantages de l'invention ressortiront d'ailleurs de la description détaillée qui va suivre en référence aux dessins annexés dans lesquels:

- la figure 1 est une vue schématique en coupe de l'injecteur d'un circuit de lecture de l'art antérieur, avec en correspondance différents profils de potentiels (a) à (g) au cours du temps ;
- la figure 2 est un diagramme de fonctionnement du système ;
- la figure 3 donne une vue schématique en coupe d'un injecteur selon l'invention avec en (a) à (e) des profils de potentiel se présentant aux différentes étapes du fonctionnement ;
- la figure 4 est un diagramme explicatif du fonctionnement ;
- et la figure 5 montre des exemples de relevés de courbes de transfert.

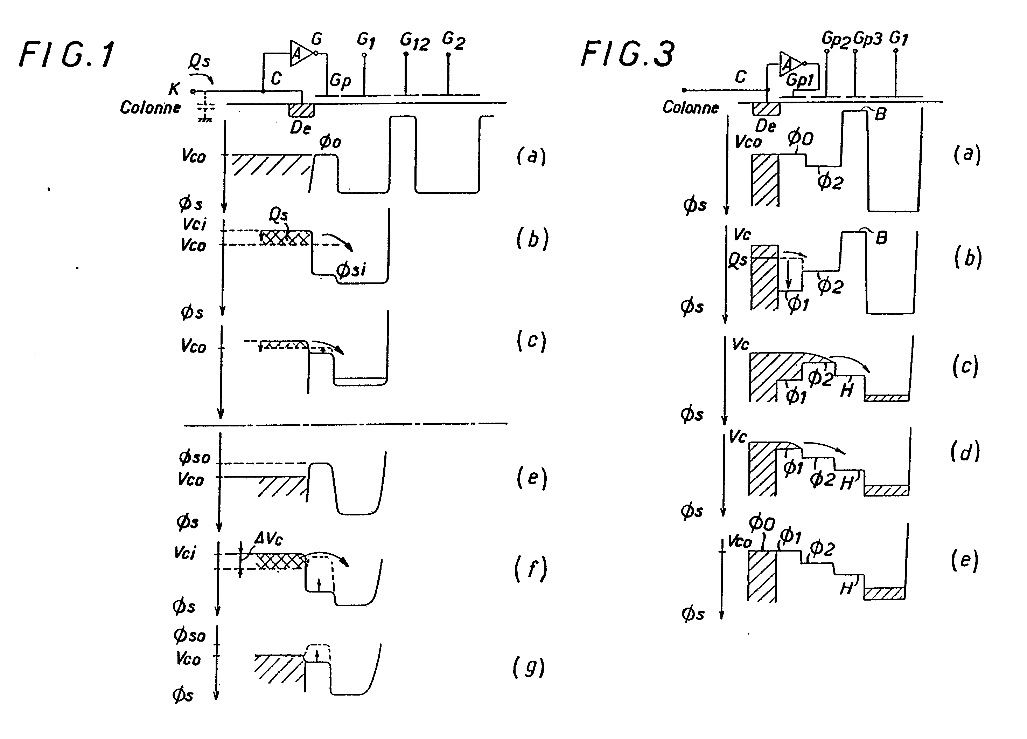

Sur la figure 1, on a représenté une diode d'entrée De associée à une grille de contrôle Gp suivie de la grille d'entrée G1 constituant la phase initiale d'une ligne de mémoire, elle-même séparée d'une grille de phase suivante G2 par une grille barrière G12.

La figure 1a représente les potentiels résultant de la lecture précédente, avant l'arrivée du signal sur la connexion de colonne K. Le potentiel Vco de la colonne est égal ou légèrement supérieur au potentiel Øs de la barrière sous la grille Gp.

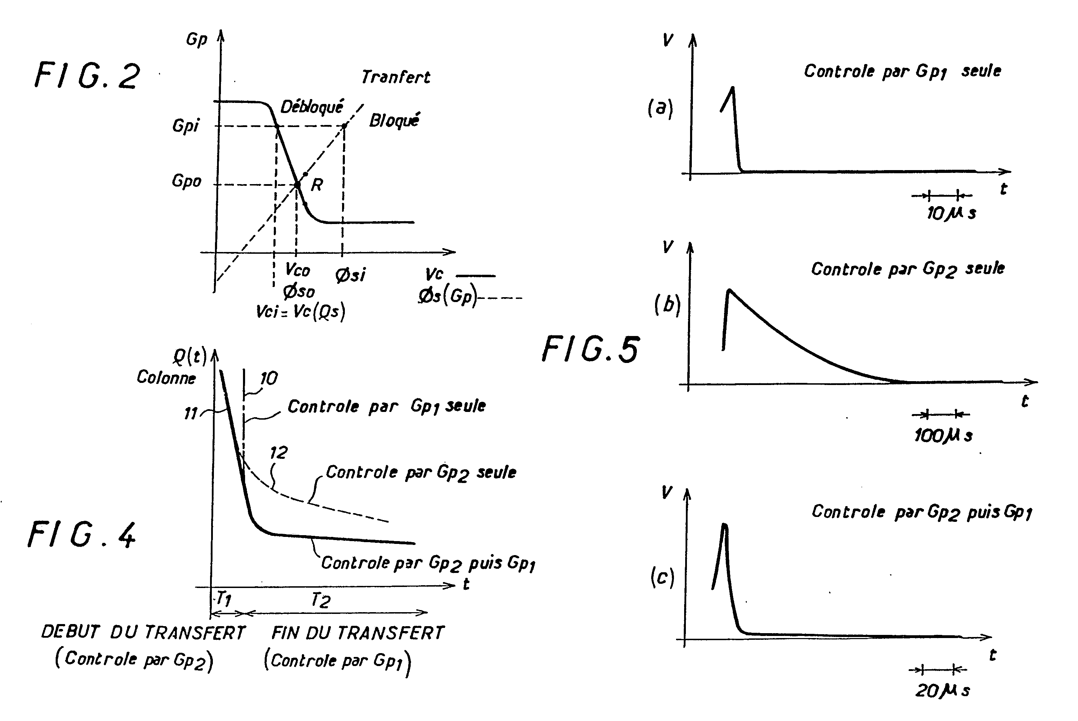

Ce point d'équilibre stable de l'injecteur est désigné par la référence R sur le diagramme de la figure 2 où l'on a représenté d'une part la caractéristique de l'amplificateur inverseur Gp (Vc), et d'autre part la caractéristique du potentiel de surface Øs sous la grille Gp. Le point R est au croisement de ces deux caractéristiques : c'est le point pour lequel le potentiel de colonne Vc s'aligne sur le potentiel Øs de la barrière sous Gp. Toute augmentation du potentiel colonne à partir de ce point bloque plus encore le transfert. Toute diminution du potentiel colonne le débloque.

Lorsque le signal arrive sur la colonne, le potentiel de celle-ci devient Vci (figure 1b). Le potentiel en sortie de l'amplificateur devient Gpi...

Dans ces conditions le transistor MOS formé par la diode d'injection De, la grille Gp et la jonction induite sous la grille G1 se trouve polarisé dans un état où il est largement conducteur. Les charges s'écoulent donc très rapidement depuis la colonne K vers la grille G1 selon le sens de la flèche, figure 1b.

En conséquence le potentiel colonne évolue rapidement vers des tensions plus élevées. L'amplificateur répercute cette variation sur la grille Gp, ce qui se traduit par une réduction du potentiel Øs sous la grille G1, d'où réduction de la vitesse de transfert. Les potentiels évoluent donc selon les flèches de la figure 1c, jusqu'à atteindre les traits pointillés indiquant une situation où le transfert s'achève en faible inversion. On est alors ramené aux conditions initiales de la figure 1a.

Le mode de fonctionnement qui vient d'être décrit implique que l'amplificateur est assez rapide pour répercuter les variations de potentiel de la colonne sur la grille Gp avant qu'une charge trop importante n'ait quitté la colonne.

Dans le cas contraire le transfert risque d'évoluer selon un régime différent illustré par les diagrammes des figures 1e à 1g.

La quantité de charge qui quitte la colonne est plus importante que celle qui serait nécessaire pour revenir à la configuration de potentiel de la figure 1a. C'est que l'amplificateur répercute les variations de potentiel avec du retard. Lorsque la redescente de potentiel s'effectue sur Gp il s'est déjà creusé une poche de potentiel sur la colonne, ce qui conduit au profil de la figure 1e pour le transfert suivant. Les figures 1f et 1g illustrent un transfert qui se passe dans ces conditions.

La principale différence entre ces deux modes de fonctionnement est la suivante:
- dans le premier mode le transfert se termine dans une situation où le potentiel de colonne Vc et le potentiel de grille Øs convergent ensemble progressivement vers la position d'équilibre ; le canal sous Gp est alors polarisé en faible inversion ;
- dans le second mode le transfert est brusquement interrompu par la redescente du potentiel sous Gp, alors que le canal était encore polarisé en forte inversion.

L'expérience montre que dans le second mode, si le transfert est très rapide, il est aussi beaucoup plus bruyant que dans le premier mode.

L'analyse du bruit injecté em même temps que la charge signal dans ce genre de circuit montre qu'en désignant par :
en : la densité spectrale de tension de bruit à l'entrée de l'amplificateur
T : le temps de transfert et
C : la capacité de la colonne,
la charge de bruit injecté s'écrit :

$$Qn = \frac{C. \; en}{\sqrt{T}}$$

cette charge de bruit injecté constituant la source de bruit dominante dans ce circuit.

Il résulte de ceci que plus le temps de transfert est court, plus la charge de bruit est élevée.

En conséquence afin de pouvoir maîtriser ce bruit, il importe de maîtriser le temps de transfert.

C'est précisément l'objet de la présente invention de proposer une modification de structure de l'injecteur permettant de parvenir à ce résultat.

La nouvelle structure proposée permet, d'une part, de contrôler avec précision le temps du transfert dans le premier mode de fonctionnement, et, d'autre part, d'éviter le second mode, trop bruyant.

Une forme de réalisation de l'invention sera décrite en référence aux figures 3 à 5.

Suivant la forme de réalisation illustrée à la figure 3, l'injecteur comporte à la place de la grille d'injection Gp, une succession de trois grilles $Gp_1$, $Gp_2$ et $Gp_3$. Les fonctions respectives de ces trois grilles sont les suivantes :

La grille $Gp_1$ commandée par l'amplificateur de contre-réaction est destinée à contrôler la fin du transfert de charge de la colonne vers le puits de potentiel créé sous la grille G1.

La grille $Gp_2$ est commandée par une tension fixe qui impose un potentiel $Ø_2$ dans le silicium intermédiaire entre le potentiel d'équilibre $Ø_0$ et le potentiel haut de la grille suivante. Cette grille est destinée à contrôler le début du transfert.

La grille $Gp_3$ est commandée par une impulsion à deux niveaux de tension, à savoir :
- dans un premier temps un niveau bas B pour isoler la colonne du puits de potentiel sous G1 ;
- un niveau haut pour autoriser le transfert de charge.

A ce niveau haut, le potentiel dans le silicium se situe à un niveau intermédiaire entre celui de la grille $Gp_2$ et celui de la grille G1.

Cette grille $Gp_3$ a aussi pour fonction de réduire la modulation de barrière de potentiel sous $Gp_2$ introduite par l'arrivée des charges sous G1.

La figure 3a montre le profil de potentiel avant l'arrivée des charges signal sur la colonne : le potentiel $V_0$ de celle-ci se trouve sensiblement aligné sur le potentiel $Ø_0$ sous $Gp_1$, de sorte qu'on se trouve au point d'équilibre R de la figure 2.

Le potentiel fixe $Ø_2$ de $Gp_2$ est tel que $Ø_2$ se trouve à quelques centaines de millivolts au-dessus de $Ø_0$. La grille $Gp_3$ et polarisée en position basse (B). Ces conditions de potentiel résultent de la fin du transfert précédent.

Sur la figure 3b, on a représenté les potentiels au moment où les charges Qs sont apportées sur la colonne. Ceci a pour effet d'abaisser le potentiel de la colonne et en conséquence d'élever le potentiel sous $Gp_1$ à la valeur $Ø_1$ supérieure à $Ø_2$.

A l'étape suivante illustrée à la figure 3c le passage de la grille $Gp_3$ au niveau haut (H) permet de commencer le transfert. L'écrémage des charges s'effectue par rapport à la barrière de potentiel $Ø_2$ sous $Gp_2$. L'écoulement des charges est alors relativement rapide car le transistor MOS est polarisé largement dans sa zone conductrice, mais cependant sensiblement moins rapide que si la grille $Gp_1$ contrôlait le potentiel.

La figure 4 montre l'évolution de la charge présente sur la colonne en fonction du temps. Dans le début du transfert illustré à la figure 3c l'évolution de la charge Q s'effectue selon la courbe 11 en trait plein qui est celle du transfert contrôlé par $Gp_2$. Au contraire, si le transfert était contrôlé par $Gp_1$ seul, il s'effectuerait selon la courbe 10 en traits mixtes.

L'écoulement des charges provoque la redescente du potentiel $Ø_1$ sous $Gp_1$ de sorte qu'il vient un temps où ce potentiel devient inférieur au potentiel $Ø_2$ sous $Gp_2$.

On se trouve alors dans un nouveau régime de transfert représenté par la figure 3d où c'est la grille $Gp_1$ qui contrôle l'écrémage des charges.

Dans ces conditions le transfert s'achève beaucoup plus rapidement que si la grille $Gp_2$ contrôlait la

fin du transfert selon la courbe 12 en pointillés de la figure 4, mais cependant sans que puisse se produire la rupture d'équilibre qui caractérise le second mode de fonctionnement ci-dessus évoqué.

En effet, la plus grosse partie des charges s'est alors écoulée et le transistor MOS ne se trouve plus polarisé dans une zone aussi conductrice qu'au début du transfert. Il n'y a donc plus de danger que les charges s'écoulent plus vite que la redescente du potentiel sous la grille d'entrée $Gp_1$.

La figure 3e montre enfin la situation où le transfert s'achève en faible inversion avec ajustement du potentiel de la colonne sur le potentiel $Ø_1$ sous la grille d'entrée $Gp_1$.

On constate donc que le transfert s'est effectué en deux périodes successives :
- une période T1 (figure 4) où l'écrémage est contrôlé par la grille intermédiaire $Gp_2$ et où l'écoulement s'effectue moins rapidement que si le contrôle s'effectuait par la grille de contrôle $Gp_1$ ;
- une période T2 où l'écrémage est contrôlé par la grille de contrôle $Gp_1$ et où, grâce à l'action de l'amplificateur, le transfert se termine beaucoup plus rapidement que si le contrôle était assuré par la grille intermédiaire $Gp_2$.

La largeur de la période T1 par rapport à T2 peut être facilement ajustée en faisant varier la marche de potentiel entre $Ø_1$ et $Ø_2$. Ceci permet de fixer avec précision le temps du transfert sans perdre les avantages apportés par l'amplificateur de contre-réaction, à savoir la division par le gain G de la capacité apparente de la colonne.

La figure 5 donne trois relevés de courbes de transfert dans un exemple d'application de l'invention avec une capacité de colonne de 1 000 pF et un amplificateur de gain voisin de 70.

La figure 5a montre l'allure d'un transfert contrôlé par une grille d'entrée $Gp_1$ seule.

La figure 5b montre l'allure d'un transfert contrôlé par la grille médiane $Gp_2$ seule.

Et la figure 5c montre l'allure d'un transfert contrôlé successivement par $Gp_2$ puis $Gp_1$.

On constate que l'ordre de grandeur du temps de transfert est :
- de 2 µs pour la figure 5a,
- supérieure à 500 µs pour la figure 5b,
- d'environ 40 µs pour la figure 5c.

On voit nettement sur la figure 5c qu'après environ 30 µs, le transfert se poursuit encore très lentement, alors que sur la figure 5a, il est bloqué définitivement au-delà de 2 µs. Ceci illustre l'avantage du procédé selon l'invention. Il est possible d'augmenter le temps T1 de la quantité nécessaire pour parvenir au niveau de bruit désiré et conserver malgré tout un transfert rapide, tandis que dans les conditions de la technique antérieure, ou bien le transfert est très rapide (figure 5c) mais de durée non contrôlable, donc avec un bruit trop élevé, soit il est trop lent (figure 5b).

Dans la description qui précède on n'a pas mentionné la nécessité d'une charge d'entraînement pour assurer le transfert de la colonne vers l'injecteur dans de bonnes conditions, quelle que soit l'amplitude du signal.

Il importe de noter que, bien que l'amplification accélère très sensiblement le transfert, il ne dispense pas de l'emploi d'une charge d'entraînement. Celle-ci peut par contre être très sensiblement réduite par rapport à la valeur nécessaire en l'absence d'amplificateur. L'apport de cette charge d'entraînement peut s'effectuer dans le cas de l'injecteur selon l'invention par un quelconque des procédés connus :
- Remontée d'une charge à partir du dispositif de transfert de charge.
- Charge stockée sur une capacité intermédiaire que l'on fait aller et venir entre cette capacité et la colonne.
- Charge constante additionnée au signal ("bias light").
- Charge injectée sur les colonnes en même temps que le signal à l'aide d'un injecteur auxiliaire.

**Revendications**

1. Dispositif photosensible à transfert de ligne, du genre comportant entre chaque colonne conductrice d'une matrice photosensible et une entrée correspondante d'une mémoire de ligne, un injecteur constitué par une diode d'entrée reliée à la colonne et une grille dite de contrôle couplée à la colonne par un amplificateur de contre-réaction, caractérisé par l'interposition entre ladite grille de contrôle ($Gp_1$) et l'entrée (G1) de la mémoire de ligne, d'au moins une grille intermédiaire ($Gp_2$) maintenue à une tension fixe.

2. Dispositif selon la revendication 1, caractérisé en ce que ladite tension fixe est telle que la tension sous la grille intermédiaire ($Gp_2$) soit intermédiaire entre la tension d'équilibre ($Ø_0$) atteinte sous la grille de contrôle ($Gp_1$) à la fin d'un transfert de charge et la tension sous la grille de contrôle au début du transfert.

3. Dispositif selon la revendication 1 ou 2, caractérisé par une seconde grille intermédiaire ($Gp_3$) formant barrière devant l'entrée (G1) de la mémoire de ligne, sous la commande d'une impulsion à deux niveaux de tension, à savoir un niveau bas d'isolement de ladite entrée et un niveau haut autorisant le transfert de charge vers celle-ci, ce niveau haut se situant entre celui de la grille intermédiaire et celui de la grille d'entrée.

# FIG.1

$Qs$

$G$  $G_1$  $G_{12}$  $G_2$

$A$

$C$  $Gp$

$K$

Colonne

$De$

$V_{co}$  $\phi_0$  (a)

$\phi_s$
$V_{ci}$  $Qs$
$V_{co}$  (b)
$\phi_{si}$

$\phi_s$
$V_{co}$  (c)

$\phi_{so}$
$V_{co}$  (e)

$\phi_s$
$V_{ci}$  $\Delta V_c$  (f)

$\phi_s$
$\phi_{so}$
$V_{co}$  (g)

$\phi_s$

# FIG.3

$Gp_2$  $Gp_3$  $G_1$

$C$  $A$
$Gp_1$

Colonne

$De$  $B$

$V_{co}$  $\phi_0$  (a)
$\phi_2$

$\phi_s$

$V_c$  $B$
$Qs$  (b)
$\phi_1$  $\phi_2$

$\phi_s$

$V_c$  (c)
$\phi_2$  $H$
$\phi_1$

$\phi_s$

$V_c$  (d)
$\phi_1$  $\phi_2$  $H'$

$\phi_s$

$\phi_0$  $\phi_1$  (e)
$V_{co}$  $\phi_2$
$H'$

$\phi_s$

EP 0 345 119 A1

FIG. 2

FIG. 5

FIG. 4

(a) Controle par Gp1 seule — 10 μs

(b) Controle par Gp2 seule — 100 μs

(c) Controle par Gp2 puis Gp1 — 20 μs

Transfert — Débloqué — Bloqué

$V_c$ — $\phi_s(Gp)$

$V_{co}$ $\phi_{si}$
$V_{ci} = V_c(Q_s)$ $\phi_{so}$

R

$Gp_i$ — $Gp_o$

Q(t) Colonne

Controle par Gp1 seule — 10

Controle par Gp2 seule — 12

Controle par Gp2 puis Gp1 — 11

$T_1$ — $T_2$

DEBUT DU TRANSFERT (Controle par Gp2) — FIN DU TRANSFERT (Controle par Gp1)

**Office européen des brevets**

# RAPPORT DE RECHERCHE EUROPEENNE

Numero de la demande

EP 89 40 1402

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 159 430 (A.J.J. BOUDEWYNS et al.)<br>* Figure 1; colonne 4, lignes 12-33 *<br>--- | 1 | H 01 L 27/14<br>H 04 N 3/15 |
| A,D | FR-A-2 571 572 (THOMSON -CSF)<br>* Figures 1,10; revendication 1 *<br>----- | 1 | |

| DOMAINES TECHNIQUES RECHERCHES (Int. Cl.4) |
|---|
| H 01 L<br>H 04 N |

Le présent rapport a été établi pour toutes les revendications

| Lieu de la recherche | Date d'achèvement de la recherche | Examinateur |
|---|---|---|
| LA HAYE | 05-07-1989 | CARDON A. |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
 
& : membre de la même famille, document correspondant

EPO FORM 1503 03.82 (P0402)